# EUROPÄISCHE PATENTSCHRIFT

(11) **EP 4 147 264 B1**
(45) Veröffentlichungstag und Bekanntmachung des Hinweises auf die Patenterteilung: **02.07.2025**
(21) Anmeldenummer: 21724603.2
(22) Anmeldetag: 05.05.2021
(51) Int. Cl.: H01J 37/32, C23C 16/04, C23C 16/27, C23C 16/511

(54) **VORRICHTUNG UND VERFAHREN ZUR BESCHICHTUNG VON BEHÄLTERN**
DEVICE AND METHOD FOR COATING CONTAINERS
DISPOSITIF ET PROCÉDÉ POUR REVÊTEMENT DE RÉCIPIENTS

(30) Priorität: 06.05.2020 DE 102020112201; 24.06.2020 DE 102020116557
(43) Veröffentlichungstag der Anmeldung: 15.03.2023
(73) Patentinhaber: KHS GmbH, 44143 Dortmund (DE)
(72) Erfinder: LENGEFELD, Jan, 24620 Bönebüttel (DE); MEIER, Vinzent, 20251 Hamburg (DE)
(74) Vertreter: Eisenführ Speiser
(86) Internationale Anmeldenummer: PCT/EP2021/061774
(87) Internationale Veröffentlichungsnummer: WO 2021/224290

(56) Entgegenhaltungen:
- EP-A2- 0 432 573
- EP-A2- 0 459 177
- EP-A2- 0 881 197
- WO-A1-03/100125
- JP-A- 2005 002 355
- US-A1- 2018 363 141
- LOUIS LATRASSE ET AL: "2.45-GHz microwave plasma sources using solid-state microwave generators. Collisional-type plasma source", JOURNAL OF MICROWAVE POWER AND ELECTROMAGNETIC ENERGY, vol. 51, no. 1, 2 January 2017 (2017-01-02), US, pages 43 - 58, XP055564796, ISSN: 0832-7823, DOI: 10.1080/08327823.2017.1293589

## Beschreibung

Die Erfindung betrifft eine Vorrichtung zur Beschichtung von Behältern mit den Merkmalen des Oberbegriffs des Anspruchs 1. Außerdem betrifft die Erfindung ein Verfahren zur Beschichtung von Behältern mit den Merkmalen des Oberbegriffs des Anspruchs 6.

Eine derartige Vorrichtung und ein derartiges Verfahren sind beispielsweise aus der US 2018/0363141 A1 bekannt. Ein bereitgestelltes Prozessgas wird in einer als Plasmakammer ausgebildeten Prozesskammer, in der sich ein zu beschichtender Behälter befindet, eingeleitet. Dieses in der Prozesskammer befindliche plasmaförmige Prozessgas wird gezündet und schlägt sich damit auf dem Behälter nieder. Zur Zündung des plasmaförmigen Prozessgases wird - in Abweichung von den in der Regel verwendeten Magnetrons - ein Solid-State-Generator verwendet. Die für die Zündung benötigte Energie des Solid-State-Generators wird über eine in die Prozesskammer hineinragende Antenne, die mit dem Solid-State-Generator über ein Koaxialkabel verbunden ist, in die Prozesskammer eingebracht. Der Solid-State-Generator wird über eine Regelung, die die benötigten Daten über einen in der Prozesskammer angeordneten Sensor erhält, gesteuert. Innerhalb der Prozesskammer ist ein mikrowellendurchlässiger Quarzzylinder vorhanden, der den zu beschichtenden Behälter umgibt und ihn flüssigkeitsdicht gegenüber dem Raum abschirmt, in dem die Antenne des Solid-State-Generators angeordnet ist.

Aus der WO 03/100125 A1 ist es bekannt, eine Mehrzahl von Plasmakammern auf einem rotierenden Rad anzuordnen. Hierdurch wird eine hohe Produktionsrate von Behältern je Zeiteinheit unterstützt. Außerdem können auch Doppel- oder Mehrfachkammern als Plasmakammern eingesetzt werden.

Eine Aufgabe der vorliegenden Erfindung besteht darin, eine Vorrichtung und ein Verfahren zur Beschichtung von Behältern zu schaffen, bei denen eine vereinfachte Konstruktion der Vorrichtung eingesetzt wird.

Gelöst wird diese Aufgabe für die gattungsgemäße Vorrichtung und für das gattungsgemäße Verfahren durch die kennzeichnenden Merkmale des jeweiligen unabhängigen Anspruchs. Vorteilhafte Weiterbildungen der erfindungsgemäßen Vorrichtung und des erfindungsgemäßen Verfahrens sind in den abhängigen Ansprüchen genannt.

Dadurch, dass bei der Erfindung vorgesehen ist, dass anstatt eines Magnetrons ein Mikrowellenerzeuger, der das Plasma in der Plasmakammer zündet und aufrechterhält, in der Form eines Solid-State-Generators ausgebildet ist, wird eine verbesserte Plasmaabscheidung auf der Behälterinnenwand erzeugt, da dadurch eine verbesserte Zuverlässigkeit und eine verbesserte Prozesskontrolle gegeben ist. Dadurch, dass in der Plasmakammer kein Sensor zur Steuerung des Mikrowellenerzeugers und keine Monitordiode zur Erfassung der aktuellen Leistung vorhanden sind, wird der Aufbau und auch die Steuerung des Mikrowellenerzeugers vereinfacht.

Solid-State-Generatoren und deren Verwendung bei der Plasmaerzeugung sind z.B. in Louis Latrasse et al.: "2.45-GHz microwave plasma sources using solid state microwave generators. Collisional-type plasma source", JOURNAL OF MICROWAVE POWER AND ELECTROMAGNETIC ENERGY, Bd. 51, Nr. 1, 2. Januar2017 (2017-01-02), Seiten 43-58, XP055564796, US ISSN: 0832-7823, DOI: 10.1080/08327823.2017.1293589, beschrieben.

Erfindungsgemäß ist der mindestens eine Mikrowellenerzeuger direkt mit der mindestens einen Plasmakammer über eine am Ort der Einleitung angeordnete Quarzscheibe verbunden sein. Dadurch wird ein Bauteil, regelmäßig ein Hohlleiter, gegenüber der Verwendung eines Magnetrons eingespart, außerdem wird kein Isolauncher zur Einkopplung des Magnetrons mehr benötigt.

Vorteilhafterweise kann sich der Ort der Einleitung im Bereich der Einleitung der Prozessgasleitung, auf der diesem Bereich gegenüberliegenden Fläche der mindestens einen Plasmakammer und/oder in einem Seitenbereich der mindestens einen Plasmakammer befinden. Diese Stellen sind besonders geeignet, eine gute Funktionsfähigkeit zu gewährleisten.

Vorteilhafterweise kann sich der Ort der Einleitung im Bereich der Einleitung der Prozessgasleitung in axialer Richtung gegenüber einem Auslass der Gaslanze befinden. Dadurch kann die Gaslanze als Antenne verwendet werden und es ist keine Einkopplung über ein komplexes Quarzglas nötig. Darüber hinaus ist eine gezielte Anregung von gewünschten Moden über eine Längenänderung der Gaslanze möglich.

Vorteilhafterweise kann die Vorrichtung eine in einem Reaktorblock integrierte Kühlvorrichtung aufweisen, wobei der Solid-State-Verstärker des mindestens einen Solid-State-Generators lösbar mit dem Reaktorblock verbunden ist. Dadurch muss bei einem Tausch des Solid-State-Verstärkers nicht an dem Kühlkreislauf gearbeitet werden.

Vorteilhafterweise kann genau ein Solid-State-Verstärker und/oder genau eine Steuerungseinheit und/oder genau ein Signalgenerator und/oder genau ein Netzteil vorhanden sein. Damit können bei Vorrichtungen, die mehrere Plasmakammern aufweisen, Bauteile eingespart werden.

Dadurch, dass bei dem erfindungsgemäßen Verfahren eine Erzeugung des Plasmas ohne Sensorerfassung der eingetragenen Energiemenge und ohne Regelung des Mikrowellenerzeugers erfolgt, kann auf Sensoren in der Plasmakammer zur Erfassung der eingetragenen Energiemenge verzichtet werden, was zu einer Vereinfachung der Beschichtungsvorrichtung führt. Eine weitere Vereinfachung der Beschichtungsvorrichtung wird dadurch erzielt, dass keine Regelung des Mikrowellenerzeugers in Abhängigkeit von der Feldkonstellation erfolgt.

Vorteilhafterweise kann das Verfahren in einer erfindungsgemäßen Vorrichtung durchgeführt werden. Dabei ergeben die sich oben zu den Ausgestaltungen der erfindungsgemäßen Vorrichtung jeweils angegebenen Vorteile.

Vorteilhafterweise kann die Feldkonstellation innerhalb der Plasmakammer durch synchronisierte Ansteuerung von mindestens zwei mit der Plasmakammer verbundenen Mikrowellenerzeugern beeinflusst werden. Dadurch kann die Feldkonstellation in der Plasmakammer beeinflusst werden und es können beispielsweise Feldinhomogenitäten ausgeglichen werden.

Es versteht sich, dass die oben und nachfolgend erläuterten Merkmale und Ausführungsformen nicht nur in den jeweils angegebenen Kombinationen offenbart sind, sondern auch in Alleinstellung sowie in anderen Kombinationen zur Offenbarung gehörend anzusehen sind.

Nachfolgend wird die Erfindung anhand einer bevorzugten Ausführungsform mit Bezug auf die Zeichnungen näher erläutert. Die Zeichnungen zeigen:
- Figur 1: eine Prinzipskizze eines ersten Ausführungsbeispiels einer Vorrichtung, die in nicht erfindungsgemäßer Weise einen Hohlleiter aufweist;
- Figur 1a: eine Prinzipskizze wie Figur 1 mit Details, wobei in nicht erfindungsgemäßer Weise ein Hohlleiter vorgesehen ist,
- Figur 2: eine Prinzipskizze eines zweiten Ausführungsbeispiels einer erfindungsgemäßen Vorrichtung,
- Figur 2a: eine Prinzipskizze wie Figur 2 mit Details,
- Figur 3: eine Prinzipskizze eines dritten Ausführungsbeispiels einer erfindungsgemäßen Vorrichtung,
- Figur 3a: eine Prinzipskizze wie Figur 3 mit Details,
- Figur 4: ein schematisches Blockschaltbild einer bevorzugten Ausführungsform einer erfindungsgemäßen Vorrichtung,
- Figur 4a: ein schematisches Blockschaltbild wie Figur 4,
- Figur 5: ein schematisches Blockschaltbild einer weiteren bevorzugten Ausführungsform einer erfindungsgemäßen Vorrichtung, die in nicht erfindungsgemäßer Weise einen Hohlleiter aufweist, und
- Figur 5a: ein schematisches Blockschaltbild wie Figur 5 mit Details.

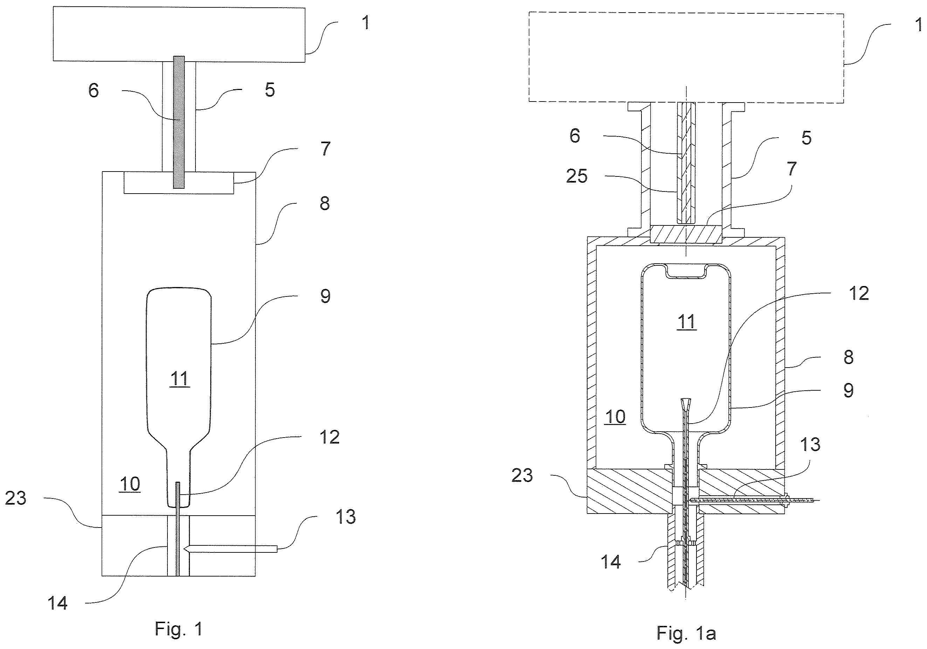

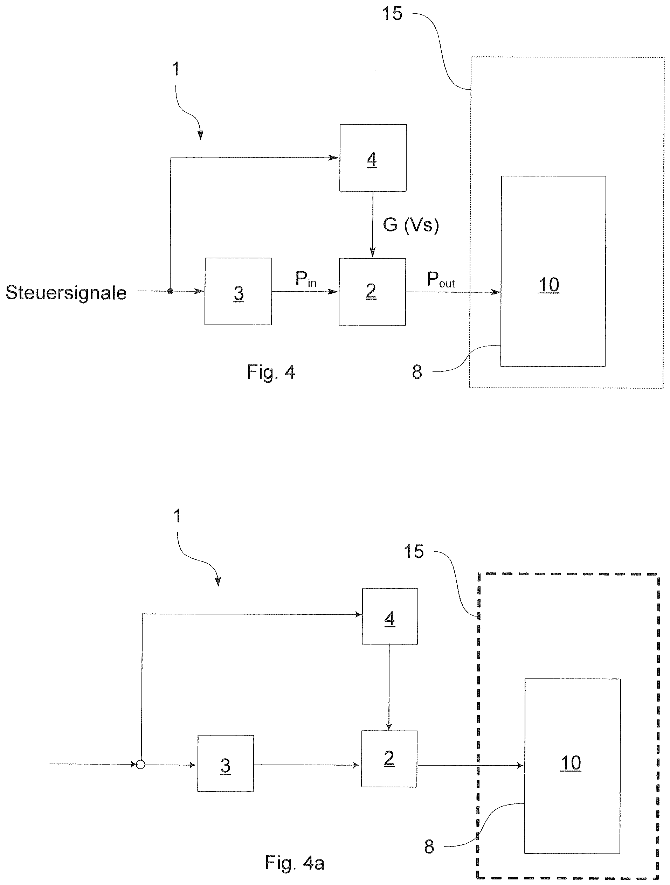

In den Figuren 1, 1a, 2, 2a, 3 und 3a sind schematisch drei Ausführungsbeispiele zur Erläuterung der Erfindung dargestellt, bei der eine Plasmastation 15 (siehe Figuren 4, 4a) genau eine Plasmakammer 8 mit genau einem Behandlungsplatz für einen Behälter 9, der einen Behälterinnenraum 11 aufweist, mit dazugehörigen Vorrichtungsmerkmalen aufweist. Von der Erfindung erfasst sind aber auch Vorrichtungen mit mehr als einer Plasmakammer 8 und auch von Plasmakammern 8, die mehr als einen Behandlungsplatz aufweisen. Liegen mehrere Plasmakammern 8 vor, so sind diese regelmäßig auf einem rotierenden (nicht gezeigten) Plasmarad angeordnet, wie es beispielsweise aus der oben genannten WO 2017/102280 A2 bekannt ist. Die Erfindung ist jedoch auch nicht auf ein rotierendes Plasmarad beschränkt, sondern umfasst insbesondere alle rotierenden oder nicht rotierende Beschichtungsmaschinen, die einen oder mehr Prozessschritte mit festen Prozessgasmischungen und kontinuierlichem Prozessgas-Verbrauch haben.

Im ersten Ausführungsbeispiel der Figur 1 ist der zu beschichtende Behälter 9 schon in seiner Aufnahmevorrichtung in einem Reaktorraum 10 der Plasmakammer 8 angeordnet und in den Behälterinnenraum 11 ist eine Gaslanze 12 von unten durch die Öffnung des Behälters 9 eingeführt.

Die zu beschichtenden Behälter 9 werden der Plasmastation 15 mittels bekannter Vorrichtungen unter Ablauf bekannter Verfahren zugeführt. Die Plasmakammer 8 weist eine Vakuumleitung 14 auf, die mit einer Vakuumeinheit (nicht gezeigt) verbunden ist und die dafür sorgt, dass der Druck im Reaktorraum 10 gesenkt wird, um ein vom einem Prozessgaserzeuger (nicht gezeigt) bereitgestelltes Prozessgas über eine Prozessgasleitung (nicht gezeigt), die in das untere Ende der Gaslanze 12 mündet, in den Behälter 9 zu saugen. Dieses Prozessgas dient zur Beschichtung der Innenwand des Behälters 9. Auch die Beschichtung geschieht mittels bekannter Verfahren. Der Unterschied zu den altbekannten Verfahren besteht in der Verwendung eines alternativen Mikrowellenerzeugers 1 in der Form eines Solid-State-Generators 1. Solche Solid-State-Generatoren 1 werden zwar seit kurzem gemäß dem oben genannten Stand der Technik prinzipiell verwendet, aber die Erfindung verzichtet gegenüber den bekannten Vorrichtungen und Verfahren auf Vorrichtungsteile, wie dies weiter unten noch ausgeführt wird.

In der Plasmakammer 8 wird im Reaktorraum 10 der Behälter 9 gas- und/oder luftdicht eingesetzt und positioniert. Ein Kammersockel 23 weist dabei eine Vakuumleitung 14 auf. Diese mündet von unten in die Plasmakammer 8 beziehungsweise stellt je nach Stellung der Gaslanze 12 zusätzlich auch eine gasdurchlässige Verbindung in den Behälterinnenraum 11 her. Insbesondere kann vorgesehen sein, dass in einem in den Behälterinnenraum 11 eingefahrenen Zustand der Gaslanze 12 der Behälterinnenraum 11 gegenüber dem Reaktorraum 10 isoliert, das heißt abgedichtet, ist, wohingegen in einem abgesenkten Zustand der Gaslanze 12 eine gasdurchlässige Verbindung zwischen dem Behälterinnenraum 11 und dem Reaktorraum 10 geschaffen wird. Es können auch noch zusätzliche Vakuumleitungen (nicht gezeigt) sowie wenigstens eine Belüftungsleitung (nicht gezeigt) angeschlossen sein. Die Gaslanze 12 kann über die (zentrale) Prozessgasleitung mit weiteren Prozessgasleitungen (nicht gezeigt) gekoppelt sein, über die jeweils unterschiedliche Prozessgaszusammensetzungen dem Behälterinnenraum 11 mittels der Gaslanze 12 zuführbar sind.

Ein typischer Behandlungsvorgang an der Plasmastation 15 wird im Folgenden am Beispiel eines Beschichtungsvorgangs kurz erläutert:
Zunächst wird der Behälter 9 unter Verwendung eines Eingaberades (nicht gezeigt) zum Plasmarad transportiert und in einem hochgeschobenen Zustand einer hülsenartigen Kammerwandung wird der Behälter 9 in die entsprechende Plasmakammer 8 eingesetzt. Nach einem Abschluss des Einsetzvorgangs wird die jeweilige Kammerwandung an dieser Plasmastation 15 in ihre abgedichtete Positionierung abgesenkt und zunächst gleichzeitig eine Evakuierung sowohl des Reaktorraumes 10 als auch des Behälterinnenraums 11 durchgeführt.

Nach einer ausreichenden Evakuierung des Reaktorraumes 10 wird die Gaslanze 12 in den Behälterinnenraum 11 eingefahren und durch eine Verschiebung eines Dichtelement eine Abdichtung des Behälterinnenraums 11 gegenüber dem Reaktorraum 10 durchgeführt. Anschließend kann der Druck im Behälterinnenraum 11 noch weitergehend abgesenkt werden. Nach Erreichen eines ausreichend tiefen Unterdrucks wird Prozessgas über die Gaslanze 12 in den Behälterinnenraum 11 des Behälters 9 an der entsprechenden Plasmastation 15 eingeleitet. Nach einer ausreichenden Prozessgaszuführung zündet der Mikrowellenerzeuger 1 das Plasma im Behälterinnenraum 11, wobei zu Erleichterung der Zündung noch eine Zündhilfe 13 im Kammersockel 23 vorgesehen ist. Die Zündhilfe 13 ragt in die Vakuumleitung 14 der Gaslanze 12 gegenüberliegend hinein. Insbesondere kann vorgesehen sein, dass mit Hilfe des Plasmas sowohl ein Haftvermittler auf der Oberfläche des Behälterinnenraums 11 als auch die eigentliche Barriere- und Schutzschicht abgeschieden wird.

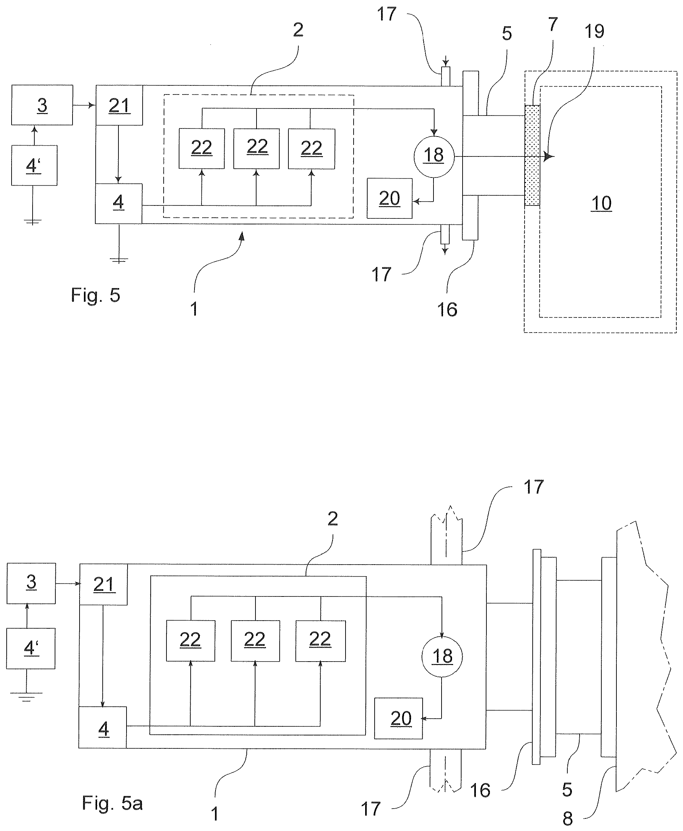

Als Mikrowellenerzeuger 1 wird ein Solid-State-Generator 1 - dessen Ausgestaltung unten noch näher in Zusammenhang mit den Figuren 4 und 5 beschrieben wird - verwendet, der mit dem Reaktorraum 10 der Plasmakammer 8 über einen in nicht erfindungsgemäßer Weise vorgesehenen Hohlleiter 5 verbunden ist und dessen Einmündung in den Reaktorraum 10 über eine Quarzscheibe 7 gasdicht abgeschlossen ist. Innerhalb des Hohlleiters 5 ist noch ein optisches Emissionsspektroskop 6 angeordnet, mit dem der Prozess überwacht und sichergestellt wird, dass die vom Solid-State-Generator 1 ausgesendeten Pulse auch im Plasma zu erkennen sind. Die Intensität der Pulse wird detektiert und es wird eine Summation aller Pulsintensitäten durchgeführt. Hieraus ergibt sich eine Bewertungsgrundlage, die als Vergleich zu einem in einem Rezept definierten Soll-Wert dient. Dadurch können zum Beispiel falsche Gaszusammensetzungen und Drücke erkannt werden. Das optische Emissionsspektroskop 6 dient nur zur Überwachung, aber nicht zur Regelung.

Erfindungsgemäß ist es so, dass abweichend vom Stand der Technik am und im Reaktorraum 8 keine Sensoren zur Steuerung des Solid-State-Generators 1 vorhanden sind. Die Steuerung des Solid-State-Generators 1 wird unten noch näher in Zusammenhang mit den Figuren 4 und 5 beschrieben.

Nach Abschluss der Plasmabehandlung wird der Behälterinnenraum 11 bis auf Atmosphärendruck belüftet. Synchron dazu kann die Gaslanze 12 aus dem Behälterinnenraum 11 abgesenkt werden. Nach einer ausreichenden Belüftung des Behälterinnenraums 11 und der Plasmakammer 8 bis vorzugsweise auf Atmosphärendruck, beziehungsweise Umgebungsdruck, wird die Kammerwandung wieder angehoben. Nachfolgend erfolgt eine Entnahme beziehungsweise Übergabe des beschichteten Behälters 9 an ein Ausgaberad (nicht gezeigt).

In Figur 1a sind einige Details des ersten Ausführungsbeispiels der Figur 1 zu erkennen. Prinzipiell gelten alle oben zur Figur 1 gemachten Ausführungen auch für Figur 1a. Zusätzlich sind noch folgende Details zu erkennen.

Die Gaslanze 12 ist an ihrem obigen Ende trichterförmig ausgestaltet, um ihre Zusetzung mit Ablagerungen zu vermindern. Der Behälter 9 schließt mit seinem Hals gasdicht mit der Vakuumleitung 14 ab, so dass die Zündhilfe 13 über die Vakuumleitung 14, in die sie hineinragt, mit dem Behälterinnenraum 11 des Behälters 9 verbunden ist und dadurch das sich im Behälterinnenraum 11 befindliche Plasma besser zum Zünden bringen kann. Die Quarzscheibe 7 verschließt eine Öffnung der Plasmakammer 8 und schließt nicht plan mit der Innenwand der Plasmakammer 8 ab, sondern springt ein wenig zurück. Das optische Emissionsspektroskop 6, das innerhalb des nicht erfindungsgemäße vorgesehenen Hohlleiters 5 angeordnet ist, ist von einem Antennenelement 25 umschlossen, durch das Energie in das Plasma eingebracht wird, um eine Zündung zu ermöglichen.

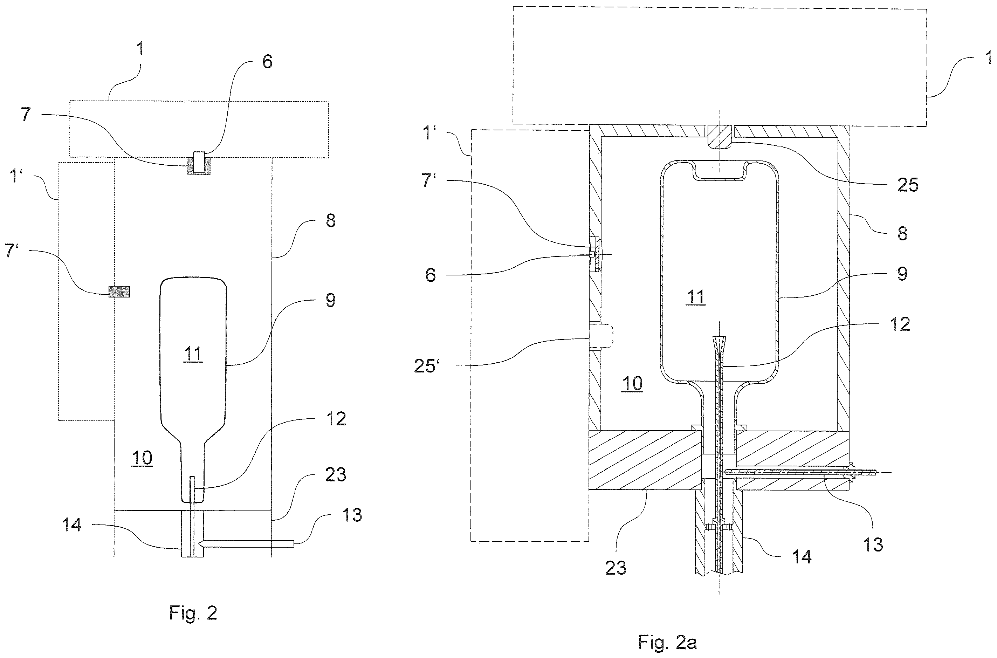

Das zweite Ausführungsbeispiel, das in Figur 2 dargestellt ist, unterscheidet sich von dem ersten Ausführungsbeispiel der Figur 1 dadurch, dass der Solid-State-Generator 1, 1' nicht über einen Hohlleiter 5 mit dem Reaktorraum 8 verbunden ist, sondern erfindungsgemäß direkt an der Wand der Plasmakammer 8 aufgesetzt ist. In Figur 2 sind zwei Positionen gezeigt, in denen der Solid-State-Generator 1, 1' angeordnet sein kann. In seiner ersten Position koppelt der Solid-State-Generator 1 seine Energie an derselben Stelle in den Reaktorraum 10, wie im ersten Ausführungsbeispiel der Figur 1, nämlich an der der Gaslanze 12 gegenüberliegenden oberen Fläche. Auch hier sind eine Quarzscheibe 7 zum gasdichten Abschluss des Solid-State-Generators 1 gegenüber dem Reaktorraum 10 und eine optisches Emissionsspektroskop 7 vorhanden.

Alternativ oder auch zusätzlich kann ein weiterer Solid-State-Generator 1' an der Plasmakammer 8 angebracht sein. Dieser ist an der Seitenwand der Plasmakammer 8 angeordnet und koppelt seine Energie über eine weitere Quarzscheibe 7' in den Reaktorraum 10 ein.

Werden zwei Solid-State-Generatoren 1, 1' verwendet, kann über eine geeignete synchrone Ansteuerung dieser beiden Solid-State-Generatoren 1, 1' die Feldkonstellation innerhalb des Reaktorraums 10 so beeinflusst werden, dass ein möglichst gutes Abscheidungsergebnis des Prozessgases auf der Oberfläche des Behälterinnenraums 11 erfolgt.

In Figur 2a sind einige Details des zweiten Ausführungsbeispiels der Figur 2 zu erkennen. Prinzipiell gelten alle oben zur Figur 2 gemachten Ausführungen auch für Figur 2a. Zusätzlich sind noch folgende Details zu erkennen.

Die Gaslanze 12 ist an ihrem obigen Ende trichterförmig ausgestaltet, um ihre Zusetzung mit Ablagerungen zu vermindern. Der Behälter 9 schließt mit seinem Hals gasdicht mit der Vakuumleitung 14 ab, so dass die Zündhilfe 13 über die Vakuumleitung 14, in die sie hineinragt, mit dem Behälterinnenraum 11 des Behälters 9 verbunden ist und dadurch das sich im Behälterinnenraum 11 befindliche Plasma besser zum Zünden bringen kann. Die Quarzscheibe 7 in der Alternative verschließt eine Öffnung der Plasmakammer 8 und schließt nicht plan mit der Innenwand der Plasmakammer 8 ab, sondern springt ein wenig zurück. Das optische Emissionsspektroskop 6 ist hinter der Quarzscheibe 7 von dem Reaktorraum 10 aus betrachtet, angeordnet. In dem oberen Bereich der Plasmakammer 8 ragt ein Antennenelement 25, das einem damit verbundenen Solid-State-Generator 1 zugeordnet ist, in den Reaktorraum 10 hinein. Bei der alternativen Anordnung des Solid-State-Generators 1' links an der Plasmakammer 8 - anstatt der Alternative, bei der der Solid-State-Generators 1 oben an der Plasmakammer 8 angeordnet ist -, ragt das mit diesem verbundene Antennenelement 25' (gestrichelt dargestellt) anstatt des oben dargestellten Antennenelements 25 in den Reaktorraum 10 hinein, durch das Energie in das Plasma eingebracht wird, um eine Zündung zu ermöglichen.

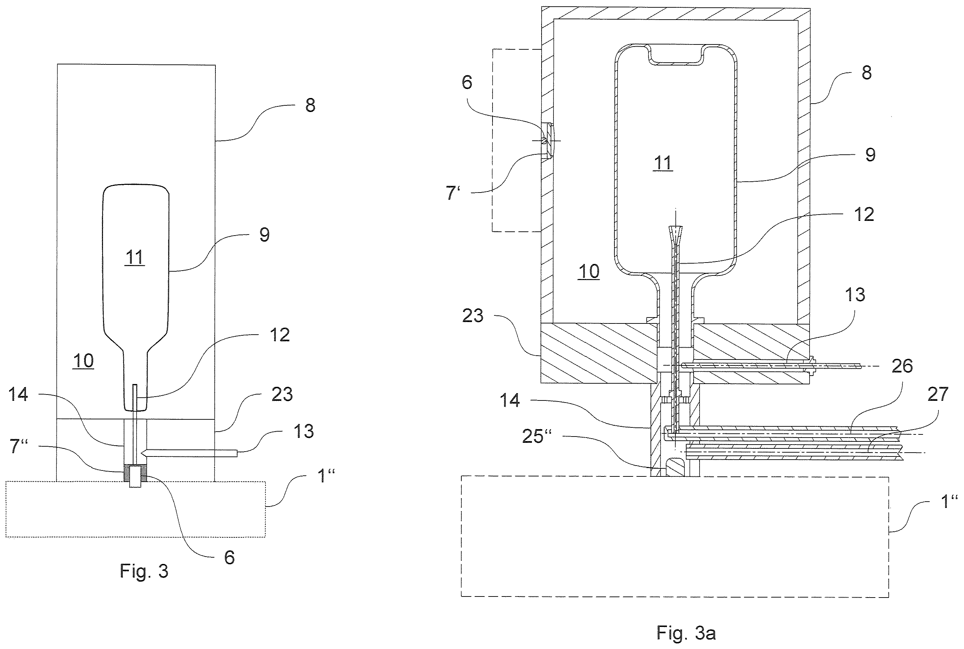

Das dritte Ausführungsbeispiel der Figur 3 ist demjenigen der Figur 2 sehr ähnlich. Es unterscheidet sich im Wesentlichen dadurch, dass ein einziger Solid-State-Generator 1" unterhalb des Kammersockels 23 angeordnet ist. Er speist seine Energie hierbei nicht direkt über die Wand der Plasmakammer 8 in deren Reaktorraum 10 ein, sondern über die Vakuumleitung 14, wobei eine Quarzscheibe 7" den gasdichten Abschluss zu dieser und somit auch zum Reaktorraum 10 gewährleistet. Von der Ausrichtung her liegt die Quarzscheibe 7" in axialer Richtung gegenüber dem Auslass der Gaslanze 12 und es ist - wie bei den anderen Ausführungsbeispielen - im Bereich der Quarzscheibe 7" ein optisches Emissionsspektroskop vorhanden.

In Figur 3a sind einige Details des dritten Ausführungsbeispiels der Figur 3 zu erkennen. Prinzipiell gelten alle oben zur Figur 3 gemachten Ausführungen auch für Figur 2a. Zusätzlich sind noch folgende Details zu erkennen.

Die Gaslanze 12 ist an ihrem obigen Ende trichterförmig ausgestaltet, um ihre Zusetzung mit Ablagerungen zu vermindern. Der Behälter 9 schließt mit seinem Hals gasdicht mit der Vakuumleitung 14 ab, so dass die Zündhilfe 13 über die Vakuumleitung 14, in die sie hineinragt, mit dem Behälterinnenraum 11 des Behälters 9 verbunden ist und dadurch das sich im Behälterinnenraum 11 befindliche Plasma besser zum Zünden bringen kann. Die Quarzscheibe 7 in der Seitenwand der Plasmakammer 8 schließt nicht plan mit deren Innenwand ab, sondern springt ein wenig zurück. Das optische Emissionsspektroskop 6 ist hinter der Quarzscheibe 7 von dem Reaktorraum 10 aus betrachtet, angeordnet. In dem unteren Bereich der Vakuumleitung 14 ragt das Antennenelement 25, das einem damit verbundenen Solid-State-Generator 1" zugeordnet ist, in einen mit dem Innenraum 11 des Behälters 9 kommunizierenden Vorraum hinein. Das untere Ende der Gaslanze 12 ist anders als in den Figuren 1, 1a, 2 und 2a ausgebildet, da der Solid-State-Generator 1" die lineare Weiterführung der Gaslanze 12 und der Vakuumleitung 14 versperrt. Es ist zu erkennen, dass die Gaslanze 12 mit einer horizontal verlaufenden Prozessgaszuführungsleitung 26 verbunden ist. Parallel dazu ist eine darunter verlaufende, mit der Vakuumleitung 14 verbundene Vakuumverbindung 27 vorhanden, die zur Herstellung des Prozessgasdrucks dient. Über sie wird vor der Beschichtung Gas aus dem Reaktorraum 10 abgeführt und nach erfolgter Beschichtung des Behälters 9 wird das noch im Reaktorraum vorhandene Gas abgeführt.

Figur 4 zeigt eine schematische Darstellung, wie der Solid-State-Generator 1 prinzipiell aufgebaut ist und mit dem Reaktorraum 10 verbunden ist.

Der Solid-State-Generator 1 weist einen RF-Verstärker 2 (auch als Solid-State-Verstärker 2 bezeichnet) auf, der von einem Signalgenerator 3 eine Eingangsleistung Pᵢₙ, die über von links ankommende Steuersignale vorgegeben wird, bekommt. Mittels des RF-Verstärkers 2, der von einem Netzteil 4 mit einem Verstärkungsfaktor G (Vs) in Abhängigkeit der Versorgungsspannung der Transistoren gespeist wird, wird diese Eingangsleistung Pᵢₙ verstärkt und somit als Ausgangsleistung Pₒᵤₜ in den Reaktorraum 10 der Plasmakammer 10, die sich in der Plasmastation 15 befindet, eingespeist, um das dort vorhandene Plasma zu zünden, wie dies oben zu Figur 1 beschrieben wurde. Durch die Veränderung der Spannung kann die Ausgangsleistung des Solid-State-Generators 1 geregelt werden.

In Figur 4a ist eine abstrahierte Darstellung des schematischen Blockschaltbilds der Figur 4, bei dem auch die Textelemente weggelassen sind. Somit gelten alle oben zu Figur 4 gemachten Ausführungen auch für Figur 4a. Die Leitung ganz links transportiert die Steuersignale; zwischen Signalgenerator 3 und RF-Verstärker 2 wird die Eingangsleistung Pᵢₙ verstärkt und zwischen dem RF-Verstärker 2 wird die Ausgangsleistung Pₒᵤₜ in den Reaktorraum 10 gebracht; außerdem wird noch der RF-Verstärker 2 von dem Netzteil 4 mit einem Verstärkungsfaktor G gespeist.

In Figur 5 wird ein anderes schematisches Ausführungsbeispiel eines Solid-State-Generators 1 gezeigt. Dieser ist über einen Anschlussflansch 16 mit dem in nicht erfindungsgemäßer Weise vorgesehenen Hohlleiter 5 verbunden. Der Hohlleiter 5 schließt gasdicht über die Quarzscheibe 7 mit dem Reaktorraum 10 ab.

Der Solid-State-Generator 1 weist einen Solid-State-Verstärker 2 auf, der auf jeder Seite drei Haupttransistoren 22 aufweist (es können je nach gewünschter Leistung auch mehr oder weniger sein), die ihre Eingangsleistung von einem Netzteil 4 erhalten. Das Netzteil 4 erhält sein Steuersignal von einem Eingangstransistor 21, der als Vorverstärker dient.

Der Eingangstransistor 21 des Solid-State-Generators 1 wird von einem Signalgenerator 3 gespeist, der die Eingangsleistung für den Solid-State-Generator 1 liefert und nicht Bestandteil desselben ist. Der Signalgenerator 3 ist wiederum mit einem externen weiteren Netzteil 4' verbunden. Alternativ kann der Signalgenerator 3 auch Bestandteil des Solid-State-Generators 1 sein und durch ein externes Netzteil versorgt werden.

Das Ausgangssignal des Solid-State-Verstärkers 2 erreicht einen Zirkulator 18, der die Energie bereitgestellt, die für die Zündung und das Aufrechterhalten des Plasmas im Reaktorraum 10 benötigt wird. Der Zirkulator 18 leitet die Energie über die Einkopplung in den Reaktorraum 10 weiter. Der Energieeintrag 19 erfolgt im dargestellten Ausführungsbeispiel über den Hohlleiter 5; dies kann aber auch durch andere Antennenkonzepte geschehen. Im Zirkulator 18 wird die Leistung gerichtet. Zur Steuerung des Energieeintrags 19 weist der Solid-State-Generator 1 einen eingehenden und einer ausgehenden Sensoranschluss 19 auf, die mit einem entsprechenden Sensor, beispielsweise in der Form einer Monitordiode (die keinen Bezug zur Plasmakammer 8 hat), verbunden sind. Wichtig ist im Zusammenhang mit der Erfindung, dass im Unterschied zum Stand der Technik, beispielsweise der oben angegebenen US 2018/0363141 A1, kein Sensor verwendet wird, der Zustände innerhalb des Reaktorraums 10 erfasst und der Solid-State-Verstärker 1 auch keine Informationen über die aktuelle Leistung, des Energieeintrags 19 aus dem Reaktorraum 10 erhält. Vielmehr wird durch den oben dargestellten Sensoranschluss 17 die hinlaufende Leistung (Welle) detektiert und durch den unten dargestellten Sensoranschluss 17 wird die rücklaufende Leistung (Welle) detektiert. Durch die Sensoranschlüsse 17 wird nur überwacht, ob die Leistung aus dem Zirkulator 18 herauskommt, die gewünscht ist. Zur Aufnahme der richtungsfalschen Leistung des Zirkulators 18 ist ein Absorptionselement vorhanden, der beispielsweise als Wassersack oder Widerstand ausgebildet sein kann.

Es folgen Spezifikationen, was für Bauteile verwendet werden und welche Kennzahlen diese aufweisen. Diese sind nur beispielhaft und beschränken die Erfindung keinesfalls.

Als Haupttransistoren 22 werden LD MOS, die zur Gleichrichtung dienen, mit einer Leistung von 250-330 W (eventuell gespiegelt, so dass insgesamt sechs solcher Haupttransistoren 22 vorhanden sind) und der Eingangstransistor 21 hat eine Leistung von 20-150 W, idealerweise 25-100 W. Das interne Netzteil 4 muss variabel sein und hat eine Spannung von 40-60 V DC, hingegen weist das externe Netzteil 4' eine Spannung von nur 5-12 V auf. Der Zirkulator 18 bringt eine Leistung von circa 2 kW über den Bereich von 1-5 kW, idealerweise 1,5-4 kW, in den Reaktorraum 10 ein. Das externe Netzteil 4' liefert eine Spannung von 5-12 V. Als Signalgenerator 3 wird ein in Eigenfrequenz arbeitender VCO oder PLL verwendet, mit einem HF-Schalter zum Pulsen, beispielsweise ein angeregter Quarzkristall. Er weist eine Leistung von im Bereich von 0,5-15 mW, insbesondere circa 1 mW, auf.

In Figur 5a sind einige Details der Verbindung des Solid-State-Generators 1 mit der Plasmakammer 8 zu erkennen, die geringfügige Abwandlungen gegenüber dem in Figur 5 dargestellten Ausführungsbeispiel aufweisen. Prinzipiell gelten alle oben zur Figur 5 gemachten Ausführungen auch für Figur 5a.

Es sind folgende Änderungen vorhanden: Der Anschlussflansch 16 des Solid-State-Generators 1 ist mit einem Anschluss des in nicht erfindungsgemäßer Weise vorgesehenen Hohlleiters 5 verbunden; dieser ist an seinem anderen Ende über einen weiteren Anschluss an der Plasmakammer 8 angebracht. Außerdem wurde auf die Quarzscheibe 7 der Figur 5 verzichtet, die nicht nötig ist, da keine optische Messung über ein optisches Emissionsspektroskop 6, wie in den Ausführungsbeispielen der Figuren 1, 1a, 2, 2a, 3 und 3a durchgeführt wird. Der Abstand des Anschlussflansches zum Gehäuse des Solid-State-Generators 1 bringt keine technische Veränderung mit sich. Es wurde auch auf den Pfeil zur Darstellung des Energieeintrags 19 wie in Figur 5 verzichtet; der Energieeintrag 19 erfolgt aber gleich, wie zu Figur 5 ausgeführt.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrundeliegende Erfindungsgedanke verlassen wird. Die Erfindung wird durch die Ansprüche definiert.

## Patentansprüche

1. Vorrichtung zur Beschichtung von Behältern (9) mittels eines Plasmaverfahrens, aufweisend mindestens eine Plasmastation (15),
die mindestens eine Plasmakammer (8) mit mindestens einem Behandlungsplatz mit einer Behälteraufnahme umfasst, in welche mindestens ein Behälter (9) mit einem Behälterinnenraum (11) an dem Behandlungsplatz einsetzbar und positionierbar ist,
wobei die jeweilige Plasmakammer (8) eine mit einer Vakuumeinheit verbundene Vakuumleitung (14) aufweist, über die sie zumindest teilweise evakuierbar ist,
wobei die jeweilige Plasmakammer (8) eine Gaslanze (12) aufweist, die in den Behälterinnenraum (11) einführbar ist,
wobei die Gaslanze (12) mit einer Prozessgasleitung verbunden ist, über die ein von einem Prozessgaserzeuger bereitgestelltes Prozessgas in den Behälterinnenraum (11) zu dessen Beschichtung gelangt,
wobei die jeweilige Plasmakammer (8) mit mindestens einem Mikrowellenerzeuger (1, 1', 1") verbunden ist und der Mikrowellenerzeuger (1, 1', 1") eine Steuerungseinheit, einen Signalgenerator (3) und ein Netzteil (4, 4') aufweist,
der mindestens eine Mikrowellenerzeuger (1, 1', 1") ein Solid-State-Generator ist, der einen Solid-State-Verstärker (2) umfasst,
**dadurch gekennzeichnet, dass**
in der mindestens einen Plasmakammer (8) kein Sensor zur Steuerung des Mikrowellenerzeugers (1, 1', 1") und keine Monitordiode zur Erfassung seiner aktuellen Leistung vorhanden sind, wobei
der mindestens eine Mikrowellenerzeuger (1, 1', 1") direkt mit der mindestens einen Plasmakammer (8) über eine am Ort der Einleitung angeordnete Quarzscheibe (7, 7', 7") verbunden ist.

2. Vorrichtung nach Anspruch 1, wobei sich der Ort der Einleitung im Bereich der Einleitung der Prozessgasleitung, auf der diesem Bereich gegenüberliegenden Fläche der mindestens einen Plasmakammer (8) und/oder in einem Seitenbereich der mindestens einen Plasmakammer (8) befindet.

3. Vorrichtung nach Anspruch 2, wobei sich der Ort der Einleitung im Bereich der Einleitung der Prozessgasleitung in axialer Richtung gegenüber einem Auslass der Gaslanze (12) befindet.

4. Vorrichtung nach einem der Ansprüche 1 bis 3 mit einer in einem Reaktorblock integrierten Kühlvorrichtung, wobei der Solid-State-Verstärker (2) des mindestens einen Solid-State-Generators (1, 1', 1") lösbar mit dem Reaktorblock verbunden ist.

5. Vorrichtung nach einem der Ansprüche 1 bis 4, wobei genau ein Solid-State-Verstärker (2) und/oder genau eine Steuerungseinheit und/oder genau ein Signalgenerator (3) und/oder genau ein Netzteil (4) vorhanden sind.

6. Verfahren zur Beschichtung von Behältern (9) in einer Vorrichtung zur Beschichtung von Behältern (9) mittels eines Plasmaverfahrens, welches folgende Verfahrensschritte umfasst:
- Einsetzen und Positionieren eines Behälters (9) mit einem Behälterinnenraum (11) an einem Behandlungsplatz einer Plasmakammer (8) einer Plasmastation (15),
- zumindest teilweises Evakuieren der jeweiligen Plasmakammer (8), um ein vom einem Prozessgaserzeuger bereitgestelltes Prozessgas in den Behälter (9) zu saugen,
- Beschichtung des Behälterinnenraums (11) mittels Plasmabehandlung,
- Erzeugung des Plasmas aus dem Prozessgas mittels eines Mikrowellenerzeugers (1, 1', 1") in der Form eines Solid-State-Generators,
**dadurch gekennzeichnet, dass**
- die Erzeugung des Plasmas ohne Sensorerfassung der eingetragenen Energiemenge in der Plasmakammer (8) erfolgt und keine Regelung des Mikrowellenerzeugers (1, 1', 1") in Abhängigkeit von der Feldkonstellation vorgenommen wird, wobei
der mindestens eine Mikrowellenerzeuger (1, 1', 1") direkt mit der mindestens einen Plasmakammer (8) über eine am Ort der Einleitung angeordnete Quarzscheibe (7, 7', 7") verbunden wird.

7. Verfahren nach Anspruch 6, wobei es in einer Vorrichtung nach einem der Ansprüche 1 bis 5 durchgeführt wird.

8. Verfahren nach einem der Ansprüche 6 oder 7, wobei die Feldkonstellation innerhalb der Plasmakammer (8) durch synchronisierte Ansteuerung von mindestens zwei mit der Plasmakammer (8) verbundenen Mikrowellenerzeugern (1, 1', 1") beeinflusst wird.

## Claims

1. Device for coating containers (9) by means of a plasma method,
comprising at least one plasma station (15) that comprises at least one plasma chamber (8) with at least one treatment station with a container holder, in which at least one container (9) with a container interior (11) can be used and positioned at the treatment station, wherein the respective plasma chamber (8) comprises a vacuum line (14) connected to a vacuum unit, by means of which it can be at least partially evacuated, wherein the respective plasma chamber (8) comprises a gas lance (12) which can be inserted into the container interior (11),
wherein the gas lance (12) is connected to a process-gas line, via which a process gas provided by a process gas generator enters the container interior (11) for its coating,
wherein the respective plasma chamber (8) is connected to at least one microwave generator (1, 1', 1") and the microwave generator (1, 1', 1") comprises a control unit, a signal generator (3) and a power supply (4, 4'), the at least one microwave generator (1, 1', 1") is a solid-state generator comprising a solid-state amplifier (2),
**characterized in that,**
in the at least one plasma chamber (8), there is no sensor for controlling the microwave generator (1, 1', 1") and no monitor diode for sensing its current power level, wherein
the at least one microwave generator (1, 1', 1") is directly connected to at least one plasma chamber (8) by means of a quartz disc (7, 7', 7") arranged at the point of introduction.

2. The device according to Claim 1, wherein the point of introduction is located in the region of the process-gas line's introduction, on the surface of at least one plasma chamber (8) opposite this region and/or in a lateral region of at least one plasma chamber (8).

3. The device according to claim 2, wherein the point of introduction is located in the region of the process-gas line's introduction in the axial direction opposite to an outlet of the gas lance (12).

4. The device according to any one of the Claims 1 to 3 comprising a cooling device integrated in a reactor block, wherein the solid-state amplifier (2) of at least one solid-state generator (1, 1', 1") is connected to the reactor block in a detachable manner.

5. The device according to any one of the Claims 1 to 4, wherein exactly one solid-state amplifier (2) and/or exactly one control unit and/or exactly one signal generator (3) and/or one power supply (4) is/are present.

6. A method for coating containers (9) in a device for coating containers (9) by means of a plasma process, comprising the following process steps:
- inserting and positioning of a container (9) with a container interior (11) at a treatment station of a plasma chamber (8) of a plasma station (15),
- at least partially evacuating the respective plasma chamber (8) in order to aspire a process gas provided by a process gas generator into the container (9),
- coating of the tank interior (11) by means of plasma treatment,
- producing plasma from the process gas by means of a microwave generator (1, 1', 1") in the form of a solid-state generator,
**characterized in that**
- the generation of the plasma takes place without sensor detection of the input amount of energy in the plasma chamber (8) and no control of the microwave generator (1, 1', 1") is carried out depending on the field constellation, wherein
the at least one microwave generator (1, 1', 1") is directly connected to at least one plasma chamber (8) by means of a quartz disc (7, 7', 7") arranged at the point of introduction.

7. The method of claim 6, wherein it is carried out in an device according to any one of the Claims 1 to 5.

8. The method according to any one of the Claims 6 or 7, wherein the field constellation within the plasma chamber (8) is influenced by the synchronized control of at least two microwave generators (1, 1', 1") connected to the plasma chamber (8).

## Revendications

1. Dispositif de revêtement de récipients (9) au moyen d'un procédé plasma, présentant au moins une station à plasma (15),
laquelle comprend au moins une chambre à plasma (8) avec au moins un emplacement de traitement avec un logement pour récipient dans lequel peut être introduit et positionné au moins un récipient (9) avec un espace intérieur (11),
la chambre à plasma (8) respective présentant une conduite d'évacuation (14) reliée à une unité d'évacuation et par elle peut, partiellement au moins, être évacuée, la chambre à plasma (8) respective présentant une lance à gaz (12) pouvant être introduite dans l'espace intérieur (11) du récipient,
la lance à gaz (12) étant reliée à une conduite de gaz de procédé par laquelle un gaz de procédé fourni par le générateur de gaz de procédé pénètre dans l'espace intérieur (11) du récipient en vue de son revêtement,
la chambre à plasma (8) respective étant reliée à au moins un générateur de micro-ondes (1, 1', 1") et le générateur de micro-ondes (1, 1', 1") présentant une unité de commande, un générateur de signal (3) et un bloc d'alimentation (4, 4'), le (les) générateur(s) de micro-ondes (1, 1', 1") étant un (des) générateur(s) à semi-conducteurs comprenant un amplificateur à semi-conducteurs (2), **caractérisé en ce que**
la (les) chambre(s) à plasma (8) ne contien(nen)t pas de capteur pour la commande du générateur de micro-ondes (1, 1', 1") et pas de diode de surveillance pour saisir sa puissance actuelle,
le (les) générateur(s) de micro-ondes (1, 1', 1") est (sont) directement relié(s) à la (aux) chambre(s) à plasma (8) par une plaque de quartz (7, 7', 7") agencée à l'endroit de l'introduction.

2. Dispositif selon la revendication 1, l'endroit de l'introduction se trouvant dans la zone de l'entrée de la conduite de gaz de procédé, sur la surface de la (des) chambre(s) à plasma (8) opposée à cette zone et/ou dans une zone latérale de la (des) chambre(s) à plasma (8).

3. Dispositif selon la revendication 2, l'endroit de l'introduction se trouvant dans la zone de l'entrée de la conduite de gaz de procédé en direction axiale en face d'une sortie de la lance à gaz (12).

4. Dispositif selon l'une des revendications 1 à 3 avec un dispositif de refroidissement intégré dans un bloc de réacteur, l'amplificateur à semi-conducteurs (2) du (des) générateur(s) à semi-conducteurs (1, 1', 1") étant relié de façon amovible au bloc de réacteur.

5. Dispositif selon l'une des revendications 1 à 4 avec un seul amplificateur à semi-conducteurs (2) et/ou une seule unité de commande un seul générateur de signal (3) et/ou un seul bloc d'alimentation (4).

6. Procédé de revêtement de récipients (9) dans un dispositif de revêtement de récipients (9) au moyen d'un procédé plasma comprenant les étapes de procédé suivantes :
- mise en place et positionnement d'un récipient (9) avec un espace intérieur (11) dans un emplacement de traitement d'une chambre à plasma (8) d'une station de plasma (15);
- évacuation au moins partielle de la chambre à plasma (8) respective pour aspirer dans le récipient (9) un gaz de procédé fourni par le générateur de gaz de procédé ;
- revêtement par traitement au plasma de l'espace intérieur (11) du récipient ;
- production du plasma à partir du gaz de procédé au moyen d'un générateur de micro-ondes (1, 1', 1") sous forme d'un générateur à semi-conducteurs,
**caractérisé en ce que**
- la production du plasma a lieu sans détection par capteur de la quantité d'énergie injectée dans la chambre à plasma (8) et sans régulation du générateur de micro-ondes (1, 1', 1") en fonction de la configuration du champ,
le (les) générateur(s) de micro-ondes (1, 1', 1") étant directement relié(s) à la (aux) chambre(s) à plasma (8) par une plaque de quartz (7, 7', 7") agencée à l'endroit de l'introduction.

7. Procédé selon la revendication 6 mis en oeuvre dans un dispositif selon l'une des revendications 1 à 5.

8. Procédé selon l'une des revendications 6 ou 7, la configuration du champ au sein de la chambre à plasma (8) étant influencée par une commande synchronisée d'au moins deux générateurs de micro-ondes (1, 1', 1") reliés à la chambre à plasma (8).
